# EUROPÄISCHE PATENTSCHRIFT

(11) **EP 1 245 078 B1**
(45) Veröffentlichungstag und Bekanntmachung des Hinweises auf die Patenterteilung: **20.08.2008**
(21) Anmeldenummer: 00987146.8
(22) Anmeldetag: 17.11.2000
(51) Int. Cl.: H03F 3/26, H03F 1/52

(54) **LEISTUNGSVERSTÄRKER UND VERFAHREN ZUM BETREIBEN EINES LEISTUNGSVERSTÄRKERS**
POWER AMPLIFIER AND A METHOD FOR OPERATING A POWER AMPLIFIER
AMPLIFICATEUR DE PUISSANCE ET PROCEDE PERMETTANT DE FAIRE FONCTIONNER UN AMPLIFICATEUR DE PUISSANCE

(30) Priorität: 03.12.1999 DE 19958442
(43) Veröffentlichungstag der Anmeldung: 02.10.2002
(73) Patentinhaber: Infineon Technologies AG, 81669 München (DE)
(72) Erfinder: SIMBÜRGER, Werner, 85540 Haar (DE); WILHELM, Wilhelm, 81477 München (DE); WEGER, Peter, 15232 Frankfurt/Oder (DE)
(74) Vertreter: Viering, Jentschura & Partner
(86) Internationale Anmeldenummer: PCT/DE2000/004051
(87) Internationale Veröffentlichungsnummer: WO 2001/041300

(56) Entgegenhaltungen:
- FR-A- 1 328 016
- US-A- 3 898 575
- US-A- 5 164 679
- US-A- 5 856 760
- PATENT ABSTRACTS OF JAPAN vol. 008, no. 095 (E-242), 2. Mai 1984 (1984-05-02) & JP 59 012609 A (TOKYO SHIBAURA DENKI KK), 23. Januar 1984 (1984-01-23)

## Beschreibung

Die Erfindung betrifft einen Leistungsverstärker mit wenigstens einem Leistungstransistor.

Die Erfindung betrifft ferner ein Verfahren zum Betreiben eines mindestens einen Leistungstransistor enthaltenden Leistungsverstärkers.

Transistorverstärker finden auch bei sehr hohen Frequenzen Verwendung. Es ist bekannt, dass beim Entwurf der Schaltung außer den Transistoreigenschaften bei hohen Frequenzen auch die Hochfrequenzeigenschaft von Bauteilen und Leitungen zu berücksichtigen sind. Bei Hochfrequenz-Schaltungen werden daher alle komplexen Vierpol-Parameter des Transistors berücksichtigt.

Es ist ferner bekannt, dass beim Entwurf integrierter Hochfrequenz-Leistungsverstärker ein Kompromiss zwischen hoher Spannungsfestigkeit (Durchbruch) und hoher Schaltgeschwindigkeit (hoher Wirkungsgrad ) gefunden werden muss. Wenn gute Eigenschaften bei niedrigen Betriebsspannungen erreicht werden sollen, ist eine hohe Transitfrequenz bei einer hohen Strom-Verstärkung erforderlich.

Aus dem Artikel von M. Rickelt und H.-M. Rein "Impact-Ionization Induced Instabilities in High-Speed Bipolar Transistors and their Influence on the Maximum Usable Output Voltage" ist dargestellt, dass die Durchbruchcharakteristik eines Bipolar-Transistors von Dotierung und Dicke eines Kollektor-Bereiches des Transistors abhängen. In dem Artikel wird ferner dargestellt, dass ein Kollektor-Strom I_{C} mit steigender Kollektor-Emitter-Spannung V_{CE} stark ansteigt (Durchbruch).

Schaltungen zum Einstellen von Ruheströmen bei einem Transistor sind aus Meinke, Gundlach: Taschenbuch der Hochfrequenztechnik, 5. Auflage, Berlin, Springer, S. F34 - F35, 1992, bekannt.

FR-A-1328 φ 16 offenbart übendies eine Schulzschallung für Transis loven in einem Leiclungsverstänker um zu verhindern, daß die Transis loven is ihvem Durch bruckbereich belrisben werden.

Weiterhin ist DE 35 86 368 T2 eine Hochfrequenzverstärkerschaltung unter Verwendung mit Leistungstransistoren bekannt. Bei dieser bekannten Verstärkerschaltung ist ein Gleichstrom leitender Pfad zwischen der Betriebspotentialquelle und dem Bezugspotential durch einen ersten Transistor und einen zweiten Transistor in Serie bereitgestellt. Das Betriebspotential der Quelle wird folglich zwischen den Transistoren aufgeteilt aufgrund des Gleichstromserienpfades, so dass jeder Transistor an der Gleichstromleistung in gleichem Maße teilhat, während getrennte, parallele Wechselstrom-Signalpfade durch jeden Transistor vorhanden sind und am Ausgang zusammengefasst werden.

Der Erfindung liegt die Aufgabe zugrunde, einen gattungsgemäßen Leistungsverstärker zu schaffen, der eine hohe Verstärkung aufweist. Vorzugsweise soll der erfindungsgemäße Leistungsverstärker eine möglichst hohe Transit-Frequenz haben.

Erfindungsgemäß wird diese Aufgabe dadurch gelöst, dass ein gattungsgemäßer Leistungsverstärker so ausgestaltet wird, dass der Leistungstransistor so geschaltet ist, dass er im Durchbruchsbereich betrieben wird und dass ein Regelkreis vorgesehen ist, welcher einen enthäll und durch den im Durchbruch entstehende Ladungsträger von einem Ausgang des Operationsverstärkers abgeführt werden.

Die Erfindung sieht vor, einen Leistungsverstärker mit einem oder mehreren Leistungstransistoren so zu betreiben, dass sich wenigstens einer der Leistungstransistoren in einem Durchbruchsbereich befindet. Der Durchbruchsbereich ist so gestaltet, dass hierdurch der jeweilige Leistungstransistor nicht zerstört wird.

Die Erfindung nutzt die Tatsache, dass die Steigung des Kollektorstroms I_{C} von einer Hilfsspannung (Bias-Spannung) abhängt. Durch eine Änderung des Quellwiderstandes der Bias-Ansteuerung, insbesondere eine niederohmige Bias-Ansteuerung wird der Anstieg des Kollektorstroms I_{C} deutlich herabgesetzt, so dass die Betriebssicherheit auch bei hohen Betriebsspannungen deutlich erhöht wird.

Es ist besonders vorteilhaft, den Leistungstransistor so zu gestalten, dass der Regelkreis wenigstens einen Transistor enthält.

Eine besonders zweckmäßige Ausführungsform des Leistungsverstärkers, beziehungsweise des Verfahrens zu seinem Betrieb, zeichnet sich dadurch aus, dass der Transistor des Regelkreises parallel zum Leistungstransistor geschaltet ist.

Es ist besonders vorteilhaft, den Leistungsverstärker so zu gestalten, beziehungsweise das Verfahren zu seinem Betrieb so durchzuführen, dass der Regelkreis eine große Zeitkonstante im Vergleich zu einer Zeitkonstante einer Ladungsträgermultiplikation aufweist und durch eine Kombination mit wenigstens einer Diode eine erhöhte Betriebssicherheit im Durchbruchsbereich ergibt.

Gegenstand der Erfindung ist ferner, ein Verfahren zum Betreiben von wenigstens einem Transistor so durchzuführen, dass der Transistor mit einem konstanten Arbeitspunkt I_{C} betrieben wird.

Hierbei ist es vorteilhaft, dass der Arbeitspunkt durch einen Regelkreis eingestellt wird. Die Schleifenverstärkung des Regelkreises wird vorzugsweise zugunsten einer besseren Stabilität kleingehalten. Bei einer Ansteuerung von Hochfrequenzsignalen wird zweckmäßigerweise ein Anstieg eines mittleren Ruhestroms bewusst zugelassen. Dadurch ist ein höherer Hochfrequenz-Wirkungsgrad des Leistungsverstärkers möglich. Beispielsweise ergibt ein Anstieg der mittleren Basisspannung bei einer Hochfrequenz-Ansteuerung um zum Beispiel 25 mV einen Anstieg des Kollektorstroms um einen Faktor von 2,7.

Weitere Vorteile, Besonderheiten und zweckmäßige Weiterbildungen der Erfindung ergeben sich aus den Unteransprüchen und der nachfolgenden Darstellung bevorzugter Ausführungsbeispiele anhand der Zeichnungen.

Von den Zeichnungen zeigt
Fig. 1 eine Schaltungsanordnung für eine Ruhestromeinstellung und
Fig. 2 einen Operationsverstärker mit einem Push-Pull-Ausgang für niedrige Versorgungsspannungen.

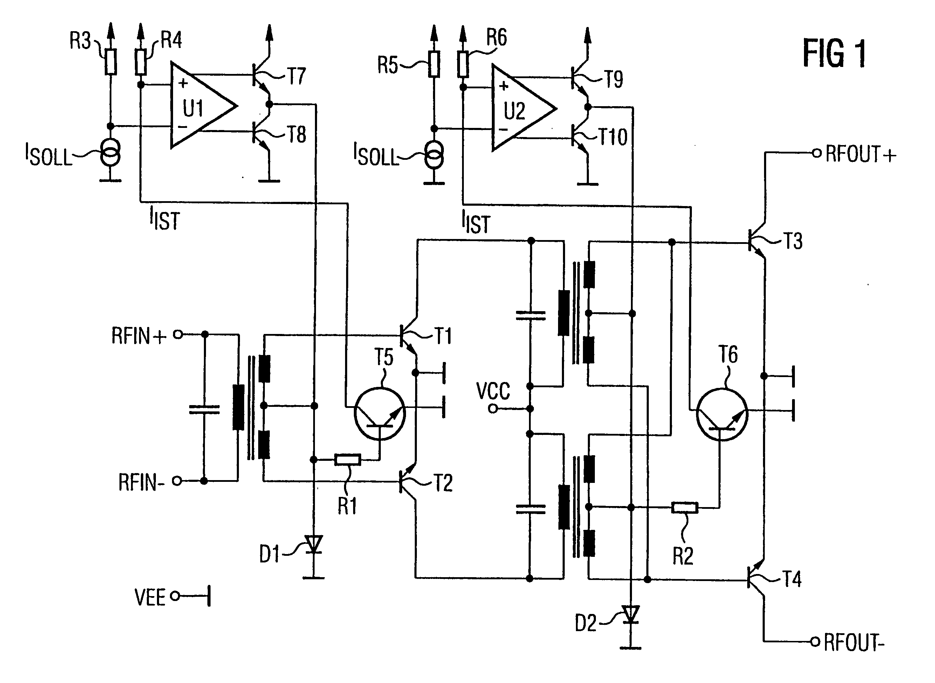

Die in Fig. 1 dargestellte Schaltungsanordnung ist vorzugsweise Bestandteil eines integrierten Hochfrequenz-Leistungsverstärkers. Die Schaltungsanordnung weist mehrere Leistungstransistoren T1, T2, T3 und T4 auf. Die Anzahl der Leistungstransistoren ist variabel und wird zweckmäßigerweise an die zu erzielende Leistungsverstärkung angepasst.

Die Leistungstransistoren T1, T2, T3 und T4 sind so geschaltet, dass sie im Durchbruchsbereich betrieben werden können. Der Ruhestrom ist weitgehend unabhängig von der Durchbruchscharakteristik der Leistungstransistoren T1, T2, T3 und T4.

Bei den Leistungstransistoren T1, T2, T3 und T4 handelt es sich vorzugsweise um schnelle Bipolar-Transistoren mit einer hohen Verstärkung und einer hohen Schaltgeschwindigkeit. Die Leistungstransistoren T1, T2, T3 und T4 weisen eine niedrige Durchbruchspannung auf.

Nachfolgend wird anhand der in Fig. 1 dargestellten Schaltungsanordnung eine bevorzugte Betriebsweise dargestellt, mit der die Transistoren im Bereich mäßiger Ladungsträgermultiplikation betrieben werden. Die Schaltungsanordnung ist so gestaltet, dass die Stabilität und Zuverlässigkeit im Betriebsbereich der mäßigen Ladungsträgermultiplikation erhöht ist.

Die Leistungstransistoren T1 und T2 bilden eine Treiberstufe, deren Ruhestrom durch einen Regelkreis eingestellt wird. Der Regelkreis besteht aus einem Operationsverstärker U1 mit Transistoren T7, T8. Der Regelkreis enthält ferner einen weiteren Transistor T5, der als "Messtransistor" betrieben wird und ein Maß für den Ruhestrom in den Transistoren T1 und T2 liefert.
Das vorliegende Konzept zwingt einen Arbeitspunkt I_{C} = CONST über einen geeigneten Regelkreis, insbesondere über einen Regelkreis, der wenigstens einen Operationsverstärker enthält. Dieser Operationsverstärker hat einen komplementären Ausgang, insbesondere einen Push-Pull-Ausgang mit NPN-Transistoren T7, T8, beziehungsweise T9, T10, wodurch die Basen von T7, T8 beziehungsweise T9, T10 niederohmig angesteuert werden. Dadurch gilt V_{BE} = f(V_{CE}), wobei der Kollektor-Strom I_{C} konstant ist. Daher krümmt sich ein Ausgangskennlinienfeld mit I_{C} = CONST erst bei höheren V_{CE} nach oben, als dies mit V_{BE} = CONST oder I_{E} = CONST der Fall wäre. Die Erfindung approximiert mit I_{C} = CONST den Idealfall I_{E} = 0. Es ist also vorgesehen, die Ansteuerbedingung I_{E} = 0, mit der keine Leistungsverstärkung erzielbar ist, durch eine Bedingung zu ersetzen, bei der bei ansonsten weitgehend gleichen Bedingungen eine Leistungsverstärkung erzielt wird.

Vorzugsweise enthält die Schaltung Dioden D1, D2, die zusätzlich einen kleinen dynamischen Innenwiderstand mit einer wesentlichen kleineren Zeitkonstante als jene des Regelkreises ergeben und damit die Betriebssicherheit im Durchbruchsbereich erhöhen.

Eine Sollwertvorgabe erfolgt durch einen Stellstrom I_{SOL}, der durch einen Widerstand R₃ in eine Vergleichsspannung umgesetzt wird. Um einen Istwert des Stromes durch die Leistungstransistoren T1 und T2 zu ermitteln, ist der Transistor T5 parallel zu den Leitungstransistoren T1 und T2 geschaltet. Im dargestellten Fall sind die Emitterflächenverhältnisse so eingestellt, dass durch den Transistor T5 ein Kollektorstrom fließt, der kleiner ist als der Kollektorstrom, der durch die Leistungstransistoren T1 und T2 fließt. Vorzugsweise ist I_{C}(T1) = I_{C}(T2) = 6 x I_{C}(T5). Der Kollektorstrom I_{C}(T5) durch den Transistor T5 wird an einem Widerstand R₄ in eine Spannung umgesetzt und mit einem Sollwert verglichen. Durch den Operationsverstärker U1 ist der Regelkreis geschlossen.

Da die Transistoren T1, T2, T5 im Durchbruchsbereich betrieben werden, ist ihr Ausgangskennlinienfeld (Fig. 1) nach oben gekrümmt. Der Anstieg der Krümmung und der Einsatzpunkt (VCE) der Krümmung ist im Wesentlichen vom Innenwiderstand der Basisansteuerung und vom absoluten Wert des Kollektorstromes bei der Kniespannung (kleine VCE) abhängig.

Da T5 einen Widerstand R4 in der Kollektorleitung hat, T1 und T2 jedoch nicht, sind deren Ausgangskennlinienfelder nicht deckungsgleich (Krümmung und Einsatzspannung verschieden), weil nicht die gleiche Kollektorspannung an T1, T2, T5 anliegt. (Man könnte das durch einen Widerstand R_{C} = 1/6*R4 in den Kollektorleitungen T1, T2 auch erreichen; dies wird jedoch bewusst vermieden, um den Wirkungsgrad des Leistungsverstärkers nicht zu verschlechtern.)
Die Kennlinienfelder von T5 können jedoch mit einem Widerstand R1 in der Basisleitung von T5, an die Kennlinienfelder von T1, T2 angepasst werden, wodurch I_{C} von T5 ein genaues Maß für I_{C} in T1 und T2 ist; trotz Betrieb der Transistoren im Durchbruch (Bereich der Krümmung im Ausgangskennlinienfeld).

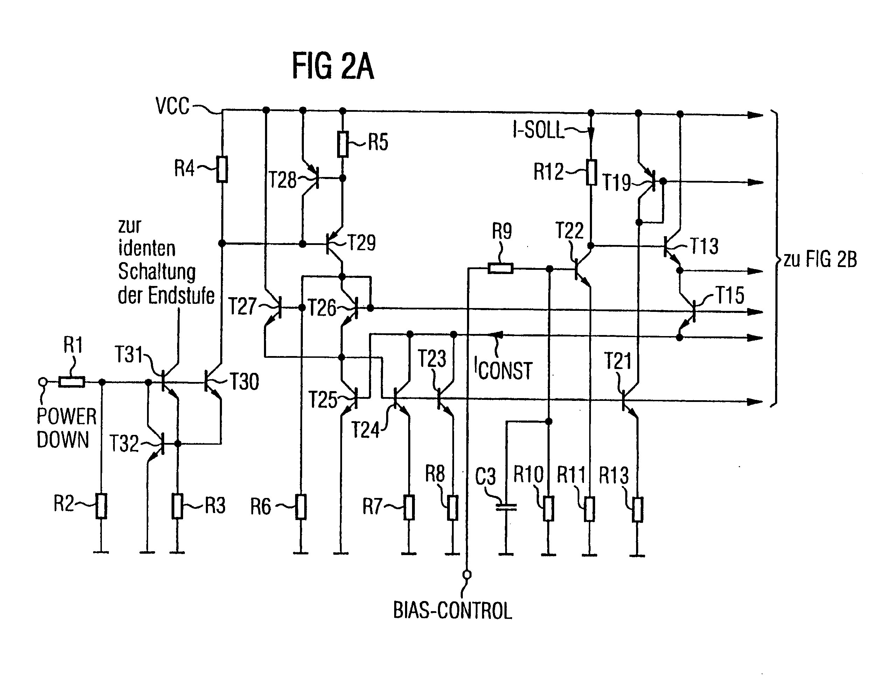

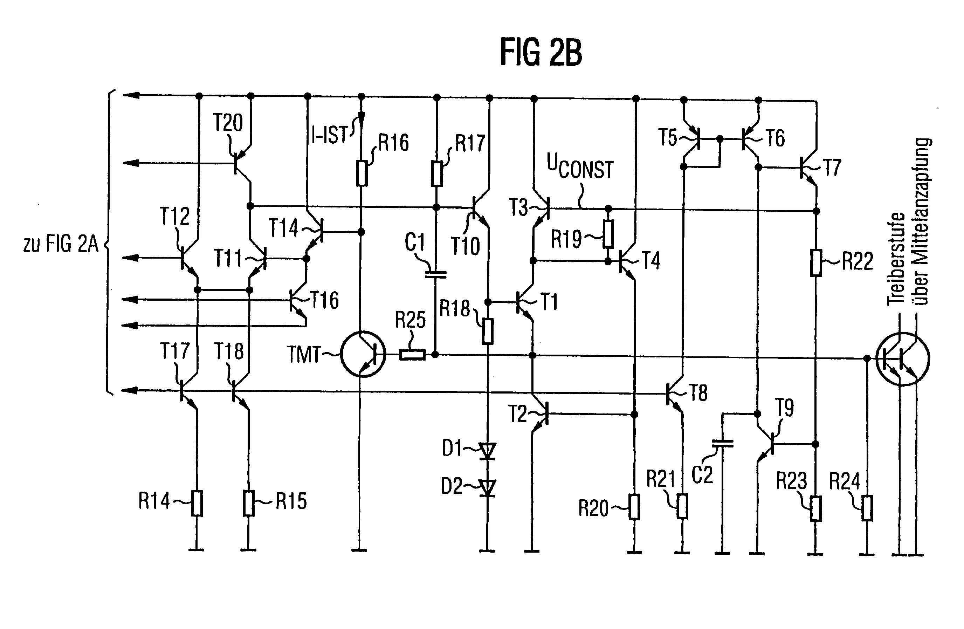

Die Krümmung des Ausgangskennlinienfeldes wird nach höheren V_{CE} geschoben, wenn der Innenwiderstand der Ansteuerquelle von T1, T2 niederohmig, möglichst 0 Ohm, wird. Deshalb ist ein Einsatz eines speziellen Operationsverstärkers U1 zweckmäßig. Ein derartiger Operationsverstärker U1 ist beispielhaft in Fig. 2 dargestellt. Der Operationsverstärker U1 hat einen Push-Pull-Ausgang T1, T2.

Hauptmerkmale des Operationsverstärkers sind ein Betrieb bei niedrigen Versorgungsspannungen ab 2,5 V, ein niedriger Ausgangswiderstand, sowie ein geeigneter Ausgang, insbesondere ein NPN Push-Pull-Ausgang.

Um den, vorzugsweise dynamischen, Innenwiderstand der Steuerquelle T7, T8 für die Basen von T1, T2 weiter zu verkleinern, ist eine Diode D1 parallel zu den Basen T1, T2 geschaltet, vorzugsweise über die Mittelanzapfung der Transformatoren. Dies trägt zu einer weiteren Erhöhung der Stabilität bei.

Die Ruhestromeinstellung der Endstufe T3, T4 erfolgt nach dem gleichen Prinzip wie bei der Treiberstufe T1, T2; jedoch mit etwa 10-20fach höheren Strömen.

Der in Fig. 1 in seinen Grundprinzipien dargestellte Operationsverstärker U1 ist in Fig. 2 im Detail dargestellt.

Um die Schaltungseigenschaften weiter zu erhöhen, wurden bei der in Fig. 2 a und Fig. 2 b dargestellten Ausführungsform weitere Transistoren und Widerstände eingesetzt.
- R3, R4, T7, T8 beziehungsweise R5, R6, T9, T10 in Fig. 1 entsprechen R12, R16, T1, T2 in Fig. 2.
- T5, R1 beziehungsweise T6, R2 in Fig. 1 entsprechen TMT und R25 in Fig. 2.
- Die Transistoren T1, T2, beziehungsweise T3, T4 in Fig. 1, sind als "markierter Doppeltransistor" in Fig. 2 (rechts neben R24) dargestellt.
- Die Diode D1 beziehungsweise D2 in Fig. 1 ist in Fig. 2 nicht dargestellt.

Der Operationsverstärker (OPV) besitzt ein abschaltbares Referenznetzwerk für die Einstellung der OPV-eigenen Ruheströme. Das Referenznetzwerk besteht aus T27, T26, T25, T23, T24, T15, T16, R6, R7, R8 und generiert einen von der Versorgungsspannung (VCC) weitgehend unabhängigen Strom I_{CONST}. Die Schaltung des Referenznetzwerkes ist Stand der Technik und kann in vielfältiger Form realisiert werden. Das Referenznetzwerk kann durch R1, R2, T32, T31, R3, T30, R4, T28, R5, T29 abgeschaltet werden. T29 liefert einen von VCC weitgehend unabhängigen Strom, welcher durch den "Power Down" Eingang mit einer Schaltschwelle von 1.2V aktiviert werden kann. Der Kollektorstrom von T29 liefert den Biasstrom für das Referenznetzwerk. I_{CONST} wird durch T21, T17, T18 und T8 gespiegelt und in skalierter Form weiterverwendet.

Der invertierende Eingang des OPV ist die Basis von T13. Der nicht invertierende Eingang des OPV ist die Basis von T14. Die Vergleichsspannungen an den Widerständen R12 und R16 (I-Soll und I-Ist) werden über die Emitterfolger T13 und T14 und den OPV-Kern T12 und T11 herangeführt. Beide Emitterfolger T13, T14 führen einen Ruhestrom von I_{CONST}/2. Entsprechend der Differenzeingangsspannung an den Basen von T11 und T12 wird ein Ausgangsstrom in die Basis von T10 geliefert. T10 treibt die Basis des Ausgangstransistors T1. Der komplementäre Zweig von T1 besteht aus T2, R20, T3, R19 und T4.

Wenn der OPV einen positiven Ausgangsstrom liefert, ist T1 aktiv. Wenn der OPV einen negativen Ausgangsstrom liefert, ist T2 aktiv. T3 ist als Kaskode von T1 geschaltet. Wenn der Strom durch T1 (und T3) hoch ist, sinkt zufolge hoher BESpannung an T3 die Basisspannung von T4 und damit T2 (T2 ist inaktiv). Umgekehrt wird T2 aktiv (über T3, T4), und T1 ist inaktiv. Damit ist ein einfacher komplementärer Ausgang T1, T2 realisiert, welcher ausschließlich aus NPN Transistoren besteht. Die Kaskadenspannung U_{CONST} von T3 wird mit dem Netzwerk T8, T5, T6, T7, R22, R23, T9 erzeugt. C2 garantiert beim Einschalten der Versorgungsspannung, dass T2 früher aktiv ist als T1. Das schützt die HF-Leistungstransistoren (T1, T2 und T3, T4 in Abbildung2) vor Zerstörung beim Einschalten der Versorgungsspannung beziehungsweise "Power-Up".

C1 wird zur Frequenzkompensation des OPV verwendet (Stand der Technik). R18, D1, D2 verbessert das dynamische Verhalten.

R17 verkleinert die "Power-Down" Abfallzeit.

R9, R19, C3, T22, R11 ist ein einfacher Spannungs-StromWandler für die Sollwertvorgabe I-SOLL. Die Steuerspannung wird am Pin "BIAS-CONTROL" zugeführt.

Das durch R16 veränderte Ausgangskennlinienfeld des "Messtransistors" TMT (im Vergleich zum Ausgangskennlinienfeld von T1, T2 beziehungsweise T3, T4 in Abbildung 2) wird mit R25 angeglichen.

Die Schaltung enthält ferner weitere Widerstände R10, R14, R15 R17 und einen Transistor T19.

### Bezugszeichenliste

- D 1: Diode
- D 2: Diode
- R 3: Widerstand
- R 4: Widerstand
- R 5: Widerstand
- R 6: Widerstand
- R 8: Widerstand
- R 9: Widerstand
- R10: Widerstand
- R11: Widerstand
- R13: Widerstand
- R14: Widerstand
- R15: Widerstand
- R16: Widerstand
- R17: Widerstand
- R18: Widerstand
- R19: Widerstand
- R20: Widerstand
- R21: Widerstand
- R22: Widerstand
- R23: Widerstand
- R24: Widerstand
- T 1: Transistor
- T 2: Transistor
- T 3: Transistor
- T 4: Transistor
- T 5: Transistor
- T 6: Transistor
- T 7: Transistor
- T 8: Transistor
- T 9: Transistor
- T10: Transistor
- T13: Transistor
- T15: Transistor
- T19: Transistor
- T21: Transistor
- T22: Transistor
- T23: Transistor
- T24: Transistor
- T25: Transistor
- T26: Transistor
- T27: Transistor
- T28: Transistor
- T29: Transistor
- T30: Transistor
- T31: Transistor
- T32: Transistor

## Patentansprüche

1. Hochfrequenz-Leistungsverstärker mit wenigstens einem Leistungstransistor (T3,T4),
bei dem der Leistungstransistor so geschaltet ist, dass er im Durchbruchsbereich betrieben wird, und
bei dem ein Regelkreis vorgesehen ist, welcher eines Operations verstärken enthält und durch den im Durchbruch entstehende Ladungsträger von einem Ausgang des Operationsverstärkers abgeführt werden.

2. Leistungsverstärker nach Anspruch 1,
bei dem der Regelkreis wenigstens einen Transistor (T6) enthält.

3. Leistungsverstärker nach Anspruch 2,
bei dem der Transistor des Regelkreises parallel zum Leistungstransistor geschaltet ist.

4. Hochfrequenz-Leistungsverstärker nach einem oder mehreren der Ansprüche 1 bis 3,
bei dem der Regelkreis eine große Zeitkonstante im Vergleich zu einer Zeitkonstante einer Ladungsträgermultiplikation aufweist und durch eine Kombination mit wenigstens einer Diode (D1, D2) eine erhöhte Betriebssicherheit im Durchbruchsbereich ergibt.

5. Verfahren zum Betreiben eines mindestens einen Leistungstransistor enthaltenden Leistungsverstärkers,
bei dem der Leistungsverstärker im Durchbruchsbereich betrieben wird und dass im Durchbruch entstehende Ladungsträger von einem Ausgang des Operationsverstärkers abgeführt werden.

## Claims

1. A high frequency power amplifier having at least one power transistor (T3, T4),
in which the power transistor is connected such that it is operated in the breakdown region, and
in which a control loop is provided, which comprises an operational amplifier, and by means of which charge carriers produced in the breakdown are carried away from an output of the operational amplifier.

2. The power amplifier as claimed in claim 1,
in which the control loop contains at least one transistor (T6).

3. The power amplifier as claimed in claim 2,
in which the transistor in the control loop is connected in parallel with the power transistor.

4. The high frequency power amplifier as claimed in one or more of claims 1 to 3,
in which the control loop has a long time constant in comparison to a time constant for charge carrier multiplication, and combination with at least one diode (D1, D2) results in improved operational reliability in the breakdown region.

5. A method for operating a power amplifier which contains at least one power transistor,
in which the power amplifier is operated in the breakdown region, and in that charge carriers which are produced in the breakdown are carried away from an output of the operational amplifier.

## Revendications

1. Amplificateur de puissance de haute fréquence, ayant au moins un transistor ( T3, T4 ) de puissance,
dans lequel le transistor de puissance est monté de manière à fonctionner dans le domaine du claquage, et
dans lequel il est prévu un circuit de régulation qui comporte un amplificateur opérationnel, par lequel des porteurs de charge créés dans le claquage sont évacués par une sortie de l'amplificateur opérationnel.

2. Amplificateur de puissance suivant la revendication 1,
dans lequel le circuit de régulation contient au moins un transistor ( T6 ).

3. Amplificateur de puissance suivant la revendication 2,
dans lequel le transistor du circuit de régulation est monté en parallèle avec le transistor de puissance.

4. Amplificateur de puissance de haute fréquence suivant l'une ou plusieurs des revendications 1 à 3,
dans lequel le circuit de régulation a une grande constante de temps par rapport à une constante de temps d'une multiplication de porteurs de charge et donne, par une combinaison avec au moins une diode ( D1, D2 ), une plus grande sécurité de fonctionnement dans le domaine du claquage.

5. Procédé pour faire fonctionner un amplificateur de puissance contenant au moins un transistor de puissance, dans lequel on fait fonctionner l'amplificateur de puissance dans le domaine du claquage, et en ce que l'on évacue des porteurs de charge créés dans le claquage par une sortie de l'amplificateur opérationnel.
